Europäisches Patentamt

European Patent Office

Office européen des brevets

(11) Publication number: **0 341 504**
**A2**

## EUROPEAN PATENT APPLICATION

(21) Application number: 89107660.6

(51) Int. Cl.⁴: **H01L 23/04 , H01L 23/50**

(22) Date of filing: 27.04.89

(30) Priority: 09.05.88 US 191624

(43) Date of publication of application:
15.11.89 Bulletin 89/46

(84) Designated Contracting States:
DE FR GB NL

(71) Applicant: **GENERAL ELECTRIC COMPANY**
**1 River Road**
**Schenectady New York 12305(US)**

(72) Inventor: **Browall, Kenneth Walter**
**1265 Sagemont Court**
**Schenectady New York 12309(US)**

(74) Representative: **Schüler, Horst, Dr. et al**
**Kaiserstrasse 69**
**D-6000 Frankfurt/Main 1(DE)**

(54) **Plastic chip carrier package and method of preparation.**

(57) An improved integrated circuit chip package is disclosed utilizing a high temperature low dielectric constant thermoplastic material which is chemically treated after molding of the thermoplastic member to improve metal adhesion. A conductive metal trace is deposited on the chemically modified thermoplastic surface to enable electrical interconnection between the chip element and external terminal means. A method to form said improved chip packge and assemble the chip element thereto is also disclosed.

Fig. 1

EP 0 341 504 A2

## PLASTIC CHIP CARRIER PACKAGE AND METHOD OF PREPARATION

### BACKGROUND OF THE INVENTION

Assorted methods have been employed to mount integrated circuit chips in plastic packages for a lower cost packaging means as compared with ceramic chip packages. The plastic package is further recognized to provide several important advantages for the chip operation as compared with ceramic packages, including higher current carrying capacity, lower dielectric constant for shorter operational time delays along with reduced inductance and capacitance. On the other hand, it is recognized that the conductive metal trace patterns generally deposited on one or more major surfaces of the chip package to enable electrical connection between the chip element and external terminal means still lack strong adhesion to the plastic substrate. One prior art endeavor to overcome such lack of adhesion is disclosed in U.S. Patent No. 4,618,739, which is also assigned to the assignee of the present invention. A multi-layer chip package is therein disclosed whereby the conductive metal trace pattern is bonded to a flexible plastic tape and the metallized tape thereafter bonded to the plastic chip package. Such means requires a precise registration between the bonded members to achieve subsequently formed electrical connection between the chip element and external terminal means which is not always achieved. Understandably, said endeavor is also more costly than simply depositing a metal trace pattern on the desired surface of the plastic chip package member.

Means have been discovered recently which do provide improved adhesion for a conductive metal trace or pattern deposited on a plastic substrate such as a printed circuit board. Such improvements are disclosed in commonly assigned patent application Serial No. 947,116, filed December 29, 1986, and application Serial No. 103,518, filed September 28, 1987. In the former application, a suitable molded thermoplastic board member, including those formed of polyimide polymer materials, and which can be either filled or unfilled, is chemically treated in a manner which improves metal adhesion without degrading the surface of the plastic substrate. The adhesion promoting agents disclosed therein comprise organic compounds containing a nitrogen-oxygen moiety in which the nitrogen atom is covalently bonded to the oxygen atom. The metal trace pattern which is subsequently deposited on the chemically modified plastic surface can be provided by a series of conventional techniques, including electroless plating, electroplating-plating, and photopatterning.

Physical abrasion of the plastic surface before the aforesaid chemical treatment is said to improve metal adhesion. In the latter pending application, circuit board members are also chemically treated to improve adhesion of a similarly deposited metal trace pattern. More particularly, the adhesion promoting chemical agents disclosed therein are organic double bond containing compounds characterized by the presence of a carbonyl or thiocarbonyl group and at least one other atom that has at least one pair of free electrons. Again, the metal trace pattern can be deposited on the chemically modified surface by a series of conventional techniques including electroplating, electroless plating, and photopatterning. Heat treatment of the metallized circuit board member is also said to improve the metal adherence with adhesion strengths of five pounds per inch being reported. Both of said commonly assigned pending applications are specifically incorporated into the present application in their entirety since the present invention represents a still further improvement employing a related chemical surface treatment.

Providing reliable electrical connection when a chip element is mounted in a chip carrier package is becoming increasingly difficult for several reasons. More particularly, it becomes necessary to electrically connect the chip element to a large number of external terminals generally located on a printed circuit board. While the surface area available on a circuit board member provides sufficient physical space to accommodate all terminal means, the generally smaller sized chip packages lack comparable space. Moreover, it is also necessary to provide additional electrical interconnection on the chip circuit package itself enabling on-board circuits to be complete with respect to the mounted chip element. Thus, there is an ever increasing demand to increase the number and complexity of circuit paths on the chip carrier member due to recent developments enlarging the complexity of the chip devices, such as very large scale integrated circuits (VLSIC). The severity of this problem alone can be illustrated by a current demand for increasingly higher lead counts in the chip carrier package as typified by pin grid arrays having 144 or more pins. Ceramic packages are limited by electrical performance. The higher dielectric constant of a ceramic material as compared with the number of commercially available polymeric materials is recognized to diminish electrical performance in the overall circuitry. Likewise, the needed thermal expansion match between the metal trace pattern and the substrate material being employed for the chip package member requires a refractory metal such as tungsten to provide circuit paths and terminal connections in a ceramic package. Greater electrical resistance for these refractory metals as compared with other conductive metals found suitable in providing electrical circuit paths, such as copper, gold, silver and nickel, is recognized to also reduce electrical performance in the overall associated circuitry. The lack of a smooth surface on a ceamic package makes it more likely that any deposited refractory metal trace pattern will encounter discontinuities thereby interrupting circuit paths and leading to circuit malfunctions and failures. Providing reliable electrical connections to a refractory metal trace pattern is also more difficult than encountered with other conductive metals.

Demand for increasing lead counts and circuit paths in typical chip carrier packages such as pin grid arrays and leadless chip carriers has led to further serious difficulties. One approach to increasing the lead count in a plastic pin grid array is disclosed in U.S. Patent No. 4,677,526 whereby a particular nested arrangement of lead frames is molded into a single layer thermoplastic body member. The means employed requires precise handling of the lead frames prior to molding in specialized carrier means as well as further manufacturing steps being required after molding to remove the carrier member. It is further recognized that a multi-layer body member construction may be needed to fulfill requirements for a higher terminal pin count since thickness of the individual pins prevents accommodation in a single layer. Multi-layer construction generally requires precise registration between the individual layers as earlier recognized and can diminish the structural integrity of the overall construction as well as increase costs of manufacture. A further need generally exists to electrically connect circuit elements in different layers of a multi-layer package construction and which understandably is increasingly difficult as the circuit elements become more crowded together. A related problem with crowding is the accompanying need to reduce thickness of the circuit paths which undesirably increases the circuit path resistance. Leadless chip carriers not only experience the same problems as packaging densities increase with package sizes also tending to decrease but are generally further limited as compared with pin grid array packages to lower lead counts. It becomes desirable, therefore, to provide a means whereby both types of chip packages can be fabricated with higher lead counts and which is further amenable to providing the higher lead count in a single layer configuration without resorting to either specialized or complicated manufacturing techniques.

A principal object of the present invention, therefore, is to provide integrated circuit packaging means of thermoplastic construction which is simpler to construct and utilize.

Another object of the present invention is to provide an integrated circuit package having high lead capability and relatively simple means for electrical interconnection between the packaged chip element and the external terminal.

Still another object of the present invention is to provide an improved integrated circuit pin grid array package fabricated by molding a high temperature low dielectric constant thermoplastic polymer with terminal pins being affixed therein.

Still another object of the present invention is to provide an improved chip carrier package with terminal connections in the form of metallized openings and fabricated by molding a high temperature low dielectric constant thermoplastic polymer with the openings already molded therein.

Another object of the present invention is to provide an improved integrated circuit package with a molded planar high temperature low dielectric constant thermoplastic body member having a more adherent conductive metal trace pattern deposited upon at least one of the major surfaces.

Still another object of the present invention is to provide an improved integrated circuit package with a molded planar low dielectric constant thermoplastic body member enabling more reliable electrical interconnection between the packaged chip element and external terminal means.

Another object of the present invention is to provide a lower cost integrated circuit package with a molded high temperature low dielectric constant thermoplastic body member.

A still further object of the present invention is to provide a simpler method to fabricate an integrated circuit package with a molded high temperature low dielectric constant thermoplastic body member.

A still further object of the present invention is to provide a method whereby a more adherent conductive metal trace can be deposited upon a molded high temperature low dielectric constant thermoplastic integrated circuit package.

A still further object of the present invention is to provide a simpler method whereby a chip element packaged in a molded high temperature low dielectric constant thermoplastic body member can be electrically interconnected to external terminal means.

These and other objects of the present invention will become apparent upon considering the further description appearing herein.

## SUMMARY OF THE INVENTION

It has been discovered that a thermoplastic integrated circuit package can be constructed to overcome the above described structural and operational problems found with the conventional articles. More particularly, a single layer configuration is now possible having higher lead counts With the presently improved mode of construction and without resorting to complex further manufacturing techniques. To effect the present improvements simply requires a molded high temperature low dielectric constant thermoplastic body member having a central chip connect recess cavity and smooth major surfaces, a plurality of terminal connections enabling electrical interconnection between the chip element and external terminal means, and an electrically conductive metal trace pattern deposited upon at least one chemically altered major surface. Said modification of the thermoplastic surface is of a particular nature providing improved metal adhesion while still preserving unmodified surface smoothness which enables a metal trace pattern to be deposited thereon having significantly closer spacing between the spaced apart conductor runs. In this manner, additional terminal connections for the mounted chip element are provided enabling interconnection between input and output terminals found on the exterior surface of the chip element and the metal trace circuit paths. As distinct from the surface treatment methods employed with printed circuit boards in both commonly assigned applications specifically incorporated herein by reference, it has now been found that any disruption or roughening of the molded thermoplastic surface before a conductive metal trace is applied produces objectionable results. A roughened surface not only interferes with producing a metal trace pattern having fine line definition especially with respect to smaller sized chip packages but makes it more difficult to bond the conventional fine wire leads now commonly employed for electrical interconnection between the mounted chip element and metal trace pattern with further commonly employed ultrasonic or thermosonic wire bonding techniques regardless of the chip package size.

The chemically modified substrate can otherwise be produced as disclosed in the aforementioned applications. Accordingly, the present treatment chemically modifies the thermoplastic surface with various already known adhesion promoting agents to increase metal adhesion while still preserving unmodified surface smoothness in the treated chip package body member. Such chemical modification of a thermoplastic polyimide surface as described in Serial No. 947,116 comprises a treatment with an organic compound containing a nitrogen-oxygen moiety in which the nitrogen atom is covalently bonded to the oxygen atom. The polyimide surface may be treated with the adhesion promoting compound by several methods, for example, spraying or flowing a solution containing the compound onto the surface, or by immersing the surface in a solution containing the compound. The solution may comprise a non-aggressive liquid, i.e., a liquid which does not materially degrade, etch, or swell the polymer surface and the adhesion promoting compound or a salt, or hydrate of the selected adhesion promoter. Illustrative adhesion promoting agents include organic alkyl compounds containing up to ten carbon atoms and organic aromatic compounds containing up to twenty carbon atoms, including organic compounds containing sulfonic groups, acyl groups, and amide groups. Suitable adhesion promoting agents include oxime compounds characterized by the presence of the nitrogen-oxygen moiety and hydroxylamine being an especially preferred adhesion promoter. Preferred polyimides include polyetherimides formed by the reaction of dianhydrides of bisphenol A with various diamines. Suitable polyimides are further said to contain various amounts of fillers or reinforcing agents, such as talcs, mica, aluminum silicates (clay), zinc oxide, precipitated or natural calcium carbonate, glass fibers, glass spheres, carbon fibers, other metal fillers, whiskers or particles, as well as mixtures thereof. Still other useful additives including pigments, ultraviolet radiation absorbing agents, impact modifiers, plasticizers, antioxidants, stabilizers, processing aids, antistatic agents and the like are said to be useful in the particular printed circuit board members being treated which is non-aggressive to the substrate polymer. The adhesion promoting compounds can be applied to the polyimide surface by a variety of techniques. For example, if the adhesion promoting compound is a solid, it may be dissolved in an aqueous or organic solvent, which is non-aggressive to the substrate polymer and applied in the form of a solution. Furthermore, some of the adhesion promoting compounds, for example, hydroxylamine, may be used in the form of a salt or hydrate, such as hydroxylamine sulfate or hydroxylamine hydrochloride. In one embodiment, the adhesion promoting compounds are incorporated into an aqueous liquid which preferably has a pH of less than about 7.0. Suitable aqueous liquids include water and mixtures of water with various acids such as hydrochloric acid, nitric acid, sulfuric acid and the like. In the preferred embodiments, the adhesion promoting compounds are incorporated into one or more organic solvents. Both type solvents must also be non-aggressive to the substrate surface. Non-aggressive liquids are those which do not discolor, weaken, or cause other deleterious effects to the bulk of the surface of the substrate when the substrate is immersed in the solvent system for a period up to about sixty minutes.

Improved metal adhesion for a polyimide printed circuit board member is provided with a similar surface treatment in the Serial No. 103,618 application. More particularly, a metal trace pattern deposited on said treated surface are rendered more adherent for representative conductive metals such as copper, palladium, nickel, gold and the like. The desired trace patterns are said to collectively define all of the electrical connections between components on a printed circuit board and are routed between appropriate locations on the board member. The particular adhesion promoting agents employed therein for chemical treatment of the polyimide surface comprise organic double bond containing compounds characterized by the presence of a carbonyl or thiocarbonyl group and at least one other atom that has one pair of free electrons. Representative agents include organic alkyl compounds containing up to about fifteen carbon atoms, organic aromatic compounds containing up to about twenty atoms, and organic alkoxy compounds containing up to about ten carbon atoms, ureas, dithiooxamides, acetamides, semicarbazides, dithiocarbamates, xanthates, and thiuramdisulfides. Again, the selected polyimide surface can be treated with said adhesion promoting agents by a variety of techniques. For example, the adhesion promoting compound can be applied directly to the surface or can be dissolved in or admixed with an aqueous or organic liquid and applied in the form of a solution or slurry. Some of the disclosed adhesion promoting compounds such as diethyldithiocarbanic acid may be used in the form of a salt or hydrate. In one embodiment, the adhesion promoting compound is incorporated into a non-aggressive solvent by either dissolving a solid adhesion promoting compound in one or more solvents or admixing a liquid adhesion promoting compound with one or more liquids. A preferred treatment medium is said to be a solution of thiourea in water due to good solubility, ready availability, ease of handling and relatively low cost for the selected agent. A typical liquid system containing the adhesion promoting compound can be applied to the surface of the polyimide substrate by any art recognized techniques, such as spraying or brushing. In preferred embodiments, the substrate is immersed in the organic or aqueous solution for a preselected period of time. The immersion or treatment time will depend on several factors, including the particular adhesion promoter used, its concentration in solution, the type of aqueous or organic liquid employed, as well as the particular polyimide material being employed. The appropriate time for treatment is said to be readily discernible without undue experimentation by those skilled in the art with typical treatment time ranges from about five minutes to about fifteen minutes and with typical liquid temperatures being maintained about 65°C and 85°C during treatment of the polyimide surface.

The surface treatment of an integrated circuit chip package according to the present invention utilizes the aforementioned known adhesion promoting agents in the same general manner as above employed. Accordingly, a high temperature low dielectric constant thermoplastic body member having a central chip recess cavity and smooth major surfaces is first molded in the conventional manner and the one or more smooth major surfaces selected for deposition of a conductive metal trace pattern then treated with an adhesion promoter which chemically modifies the thermoplastic surface to improve metal adhesion while still preserving unmodified surface smoothness. The conventional molding processes, such as injection molding, can provide such construction to still further include at least some of the terminal connections enabling electrical interconnection between the chip package and external terminal means. For example, a pin grid array package can be made with molded-in-place conductive metal terminal pins so that a subsequently deposited conductive metal trace pattern comprising a plurality of spaced apart conductor runs will interconnect the terminal pins with a mounted chip element by known connection means, such as wire-bonding. In a similar manner, a leadless chip carrier package can be molded in a planar configuration to include terminal openings extending between the top and bottom major surfaces and with said openings providing the desired terminal connections when thereafter metallized with a conductive metal coating. A conductive metal trace pattern is deposited on the major surface selected for electrical interconnection between the chip element and said terminal connections after chemical modification has been provided in accordance with the present invention. Selection of a suitable thermoplastic polymer material for the chip package depends primarily upon the means being employed for interconnection between the metal trace pattern and the mounted chip element. Since conventional chip element construction includes locations for its input and output terminals, the selected polymer material should withstand the elevated temperature required to solder leads to these terminal connections. Accordingly, the term "high temperature" as used herein to characterize a suitable thermoplastic polymer for the chip package means a thermoplastic polymer material with a melting point at least equal to the melting point of conventional soldering materials. Representative thermoplastic polymers for use in molding the chip package body member hereby includes polyimides and polysulfone, polyphenylene sulfide and polyether sulfone.

Increased adhesion of a conductive metal trace pattern to the molded thermoplastic surface is provided by surface pretreatment before chemical modification with the aforementioned adhesion promoting agents. A preferred surface pretreatment for a molded polyimide package member comprises initial cleaning of the molded surface with a degreasing agent such as 1,1,2-trichlorotrifluoroethane and thereafter removal of up to about 15 microns of the surface material with a suitable solvent, such as concentrated sulfuric acid. A residue remains on the treated surface which can be loosened for subsequent removal with a basic solution such as formed by dissolving 0.1M up to about 4.0M of a compound, including sodium hydroxide, potassium hydroxide, tetramethylammonium hydroxide, and mixtures thereof in a suitable solvent, including water, methanol, ethanol and mixtures thereof. Removing this surface residue in a manner which fully restores the original surface smoothness is achieved with a solution having the above mentioned solvents, such as dimethylformamide in methanol. Adhesion of a conductive metal trace pattern deposited after chemical modification of the pretreated molded surface with the aforementioned adhesion promoting agents is further increased with post treatment of the metallized package member. Accordingly, a molded polyimide package member which was treated in the foregoing manner and with a copper trace subsequently deposited thereon in a conventional manner was then heat treated in a temperature range from about 60°C up to about 170°C over a time period ranging from about five minutes up to about two hours.

One preferred chip carrier package according to the present invention comprises a unitary planar pin grid array constructed of high temperature low dielectric constant thermoplastic having a centrally disposed chip connect recess cavity and smooth top and bottom surfaces, molded-in-place to electrically conductive terminal pins extending from the top surface and protruding from the bottom surface of the planar body member, and an electrically conductive metal trace directly deposited on the top surface after chemical treatment which enable electrical interconnection between the chip and the terminal pins, said chemical treatment providing improved metal adhesion while still preserving unmodified surface smoothness. The planar body member is molded with the terminal pins fixed therein. The electrically conductive metal trace pattern deposited on the selected major surface after chemical modification is copper metal and with said copper metal trace being further preferably provided with a second conductive metal such as nickel or gold to better resist atmospheric corrosion of the copper metal. A polyetherimide polymer can be selected for the body member with the copper trace comprising a series of spaced apart conductor runs extending from the terminal pins to close proximity with the central recess cavity. Chemical modification of the bottom surface in the recess cavity according to the present invention followed by subsequent application of a copper film thereto provides a desirable heat-sink and with a one mil thick copper metallization having capability for a 2 watt heat dissipation capability. Understandably, the copper metal trace pattern can be varied to accommodate the desired electrical interconnection between the subsequently bonded chip element and the metallized conductor runs with no further processing operations being required other than securing said interconnections. Simple wire bonded interconnections can thereby be provided in a conventional manner to complete the final package assembly. On the other hand, it is customary to protect the interconnected chip element against atmospheric contamination so that conventional cover means can be directly bonded or adhesively secured to the top surface of the planar package member for this purpose.

A different preferred embodiment according to the present invention comprises a leadless chip carrier package having a single layer configuration and with the terminal connections for a mounted chip element extending between the top and bottom major surfaces. Specifically, the completed package member comprises a high temperature low dielectric constant thermoplastic planar body member having a central chip connect recess cavity and flat smooth top and bottom surfaces, terminal connections extending between said top and bottom surfaces in the form of electrically conductive metal coated openings, and an electrically conductive metal trace directly deposited on the top surface after chemical treatment which enables electrical interconnection between the chip and terminal connections, and said chemical treatment again providing improved metal adhesion while still preserving unmodified surface smoothness. Some of the terminal connections are located at the side edges of the planar body member in the preferred construction to enable further connection of the package with external terminal means, such as customarily provided with a printed circuit board member. Again, a copper trace pattern is deposited on the top surface of this package construction after surface treatment in accordance with the invention with said copper trace comprising a series of spaced apart conductor runs extending from the terminal connections to the central recess cavity. As above indicated, surface treatment of the bottom major surface in the recess cavity according to the present invention with subsequent metallization of the treated surface also enhances heat dissipation from a mounted chip element. An assembled leadless chip carrier package constructed in said manner thereby comprises a high temperature low dielectric constant thermoplastic planar body member having a central chip connect recess cavity and flat smooth top and bottom surfaces, terminal connections extending between said top and bottom surfaces in the form of electrically conductive metal coated openings, a chip element having input and output terminal pads located on its top surface and being bonded at its bottom surface to the bottom major surface in the central recess cavity, and an electrically conductive metal trace directly deposited on the top surface of the planar body member after chemical treatment which enables electrical interconnection between the chip and terminal connections, said chemical treatment providing improved metal adhesion while still preserving unmodified surface smoothness, wherein said interconnection between the chip and terminal connections is effected by wire elements extending from the terminal pads located on the chip to the metal trace pattern. A customary cover member bonded to the top surface of the planar body member in said construction protects the packaged chip element against atmospheric contamination during subsequent package operation. To prepare such leadless chip package assembly according to the present invention includes the steps of (a) molding a high temperature, low dielectric constant thermoplastic body member having a central chip recess cavity and smooth top and bottom surfaces which further may include through holes and/or openings extending between said top and bottom surfaces, (b) metallizing said openings with a conductive metal coating to enable electrical interconnection between the chip package and external terminal means, (c) treating at least the top surface with an adhesion promoter which chemically modifies the thermoplastic surface to improve metal adhesion while still preserving unmodified surface smoothness, (d) depositing a conductive metal trace on the chemically treated top surface to enable electrical interconnection between the chip and the metal coated openings, (e) bonding a chip element having input and output terminals to the bottom major surface in the central chip cavity, and (f) electrically connecting the input and output terminals on the chip to the conductive metal trace. It should be further appreciated, however, that preparing a chip carrier package in the foregoing manner limits terminal connections to the sides of the planar body member when initially molded. Internal terminal connections extending between the top and bottom planar surfaces are subsequently provided in the conventional manner by molding or drilling through holes in the molded body member.

## BRIEF DESCRIPTION OF THE DRAWINGS

FIG. 1 is a perspective view depicting the principal elements for a typical pin grid array integrated chip carrier package of the present invention.

FIG. 2 is a cross-sectional view showing the terminal pin construction and electrical interconnections thereto for the package depicted in FIG. 1.

FIG. 3 is a perspective view depicting the principal elements for a typical leadless chip carrier package of the present invention.

FIG. 4 is a cross-sectional view showing the terminal connections and electrical interconnections thereto for the package depicted in FIG. 3.

## DESCRIPTION OF THE PREFERRED EMBODIMENTS

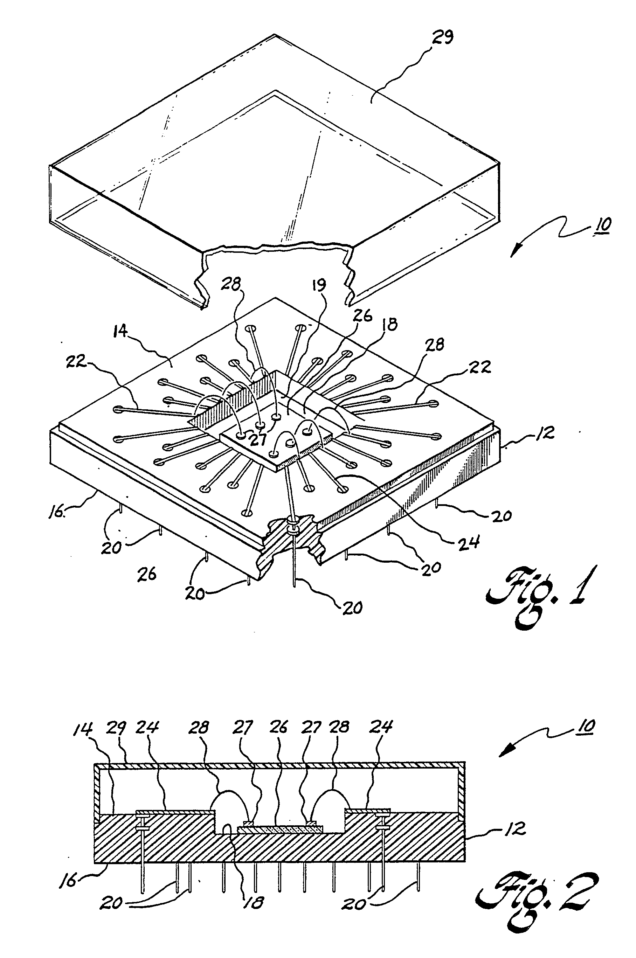

In FIG. 1 there is shown the principal elements of a chip carrier package 10 having a unitary molded plastic main body member 12, smooth top and bottom surfaces 14 and 16, respectively, and a centrally disposed chip connect recess cavity 18. Main body member 12 is formed of a high molded temperature low dielectric constant thermoplastic polymer in a planar shape of generally rectangular or square configuration having a series of conductive terminal pins 20 affixed therein when initially molded. Conductive metal terminal pins 20 extend from top surface 14 and protrude from bottom surface 16 of the main body member in ordered spatial orientation. The central chip-connect recess cavity 18 is formed as an integral part of the main body member when molded. After such chemical modification of the top surface 14, a conductive metal trace pattern 22 is deposited on the altered surface having a plurality of conductor runs 24 extending from the top of the molded-in-place terminal pins 20 to the central recess cavity 18. A chip element 26 is bonded to the major bottom surface 19 of the central recess cavity by conventional means. Chip element 26 has input and output terminals 27 located on its top surface as shown. The terminal on the chip element provide electrical interconnection to the conductive metal trace pattern 22 and thereby completing an electrical circuit between the chip element and external terminal means connected to terminal pins 20. As can be seen from the drawing, interconnection between the terminals 27 and the metal trace pattern 22 is carried out in the conventional manner with fine size wire elements 28 utilizing known ultrasonic or thermosonic welding techniques. Cover 29 can also be bonded to top surface 14 of this package construction by a variety of well known techniques.

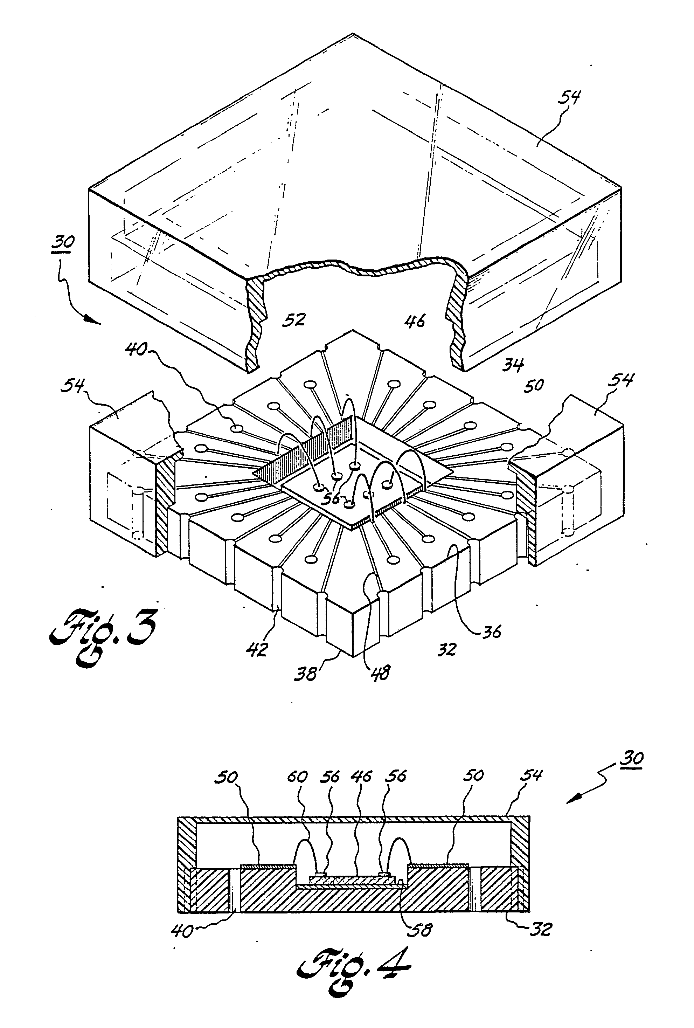

FIG. 2 provides a cross-sectional view depicting the pin grid array package in FIG. 1. Accordingly, the same numerals are employed to depict equivalent components. The simplified packaging of an integrated circuit chip in this manner with terminal pin patterns on all four sides of the rectangular chip carrier package as well as multiple pin rows and conductor runs being located on each of the sides provides maximum packaging density with lead count capability up to 144 and greater.

FIG. 3 is a perspective view showing a leadless integrated circuit chip carrier package according to the present invention and which includes a different type of terminal connection being provided in the molded body member. Said assembled package construction 30 comprises a high temperature low dielectric constant thermoplastic planar body member 32 having a central chip connect recess cavity 34 and flat smooth top and bottom surfaces 36 and 38, respectively, with terminal connections 40 extending between said top and bottom surfaces 36 and 38 being in the form of electrically conductive metal coated openings 42. A conductive metal trace patter 44 is deposited on top surface 36 of the package body member 32 after surface modification as disclosed herein. As shown, some of the coated metal openings 42 providing terminal connections for a mounted chip element 46 are located at the side edges of the planar body member 32 to provide the customary interconnection between said chip element and external terminals generally provided on a printed circuit board or other comparable electrical circuit interface. The metal coated through holes 40 disposed in the central regions of top surface 36 generally provide internal electrical circuit connections needed by said mounted chip element for its operation or to furnish still other needed internal terminals in the assembled package for such functions as testing and the like. Thus, some conductor runs 48 in the metallized trace pattern 44 extend to peripherally located metallized openings 42 whereas conductor runs 50 simply connect between interior metallized openings 40 and the central recess cavity 34. Interconnection between the input and output terminals 56 provided on the top surface of the mounted chip element 46 and conductor runs 48 or 50 thereby completes the electrical circuitry for said packaged construction. As previously described, chip element 46 is bonded to the bottom major surface 52 in said central recess cavity 34. Heat dissipation when the bonded chip element is operating can be enhanced according to the present invention with a conductive metal film being deposited on the bottom surface 52 in said central recess cavity. Accordingly, the bottom surface in said recess cavity can be chemically altered in the same manner employed for treatment of the top surface layer 36 and a conductive metal layer applied thereon in an otherwise conventional manner. Alternately, the bottom major surface in the central recess cavity can be formed to include a metal heat-sink plate when the planar body is initially molded.

In FIG. 4 there is shown a cross-sectional view of the assembled package 30 having the chip element both physically mounted and electrically interconnected in the final assembly. Accordingly, the same numerals are employed as previously used in FIG. 3 embodiment description to depict the same components in said final assembly and with only added numerals 58 and 60 depicting components not readily viewed in the preceding drawing. As can be noted in the present drawing, the mounted chip element 46 is disposed on a conductive metal film 58 positioned on the bottom major surface 56 of the central recess cavity. It can be further noted in the present drawing that electrical interconnection between said mounted chip element 46 and metallized through holes 40 serving as terminal connections in the planar body member 32 is accomplished with wire elements 60 that are soldered or otherwise connected to the metallized conductor runs 50. Said wire elements 60 can be seen as connected at one end to input and output terminals 56 provided on the top surface of the chip element while being connected at the opposite end to the metallized conductor runs 50. It is further contemplated that both the metal trace pattern and conductive film 58 can be deposited jointly in a conventional manner such as with a photoresist pattern or other photopatterning techniques. As will be further apparent to one skilled in this art, the bottom major surface 38 in body 32 can also be processed in accordance with the present invention to provide an additional conductive metal trace pattern thereon should still other circuit connections in the packaged assembly prove desirable.

It will be apparent from the foregoing description that broadly useful means have been provided to increase lead counts in an integrated circuit chip package and with relatively simple processing techniques. It will be apparent, however, that modifications can be made in the specific embodiments above described without departing from the spirit and scope of the present invention. For example, it is contemplated that still other high temperature low dielectric constant polymer materials other than herein specifically identified can be processed according to the present invention although different adhesive promoting agents may have to be employed. It will be further evident to one skilled in the art that encapsulation of the packaged chip element with already known moisture impervious sealants can prove beneficial since plastic chip packages do not provide a hermetic enclosure. Moreover, it should be possible to achieve still greater packaging density in multi-layer integrated circuit chip packages by processing a deposition of conductive metal trace patterns on the individual layers in accordance with the present invention. It is intended to limit the present invention, therefore, only by the scope of the appended claims.

## Claims

1. An integrated circuit chip package comprising a high temperature low dielectric constant thermoplastic body member having a central chip connect recess cavity and smooth major surfaces, a plurality of terminal connections enabling electrical interconnection between the chip package and external terminal means, and a metallized electrically conductive pattern on at least one chemically treated major surface to enable electrical interconnection between the chip and the terminal connections, wherein said chemically treated surface provides improved adhesion for the metallized pattern.

2. The chip package of claim 1 wherein the terminal connections extend between the major surfaces of the thermoplastic body members.

3. The chip package of claim 2 wherein the terminal connections comprises conductive metal pins.

4. The chip package of claim 3 wherein the conductive metal pins protrude beyond one major surface.

5. The chip package of claim 2 wherein the terminal connections comprise metallized openings.

6. The chip package of claim 5 wherein some of the terminal connections are located at the side edges of the thermoplastic body member.

7. The chip package of claim 1 wherein the electrically conductive metal pattern is copper metal.

8. The chip package of claim 7 wherein another electrically conductive metal is deposited upon the copper metal pattern.

9. The chip package of claim 8 wherein nickel metal is deposited upon the copper metal trace.

10. The chip package of claim 8, wherein gold or nickel metal is deposited upon the copper metal pattern.

11. The chip package of claim 1 wherein the bottom major surface in the central chip cavity has a metallized thermally conductive layer directly deposited thereon.

12. The chip package of claim 1 wherein the high temperature low dielectric constant thermoplastic is polyetherimide.

13. The chip package of claim 1 wherein the electrically conductive metal pattern comprises a series of spaced apart conductor runs extending from the terminal connections to the central chip cavity.

14. A pin grid array integrated circuit chip carrier package comprising a high temperature low dielectric constant thermoplastic planar body member having a centrally disposed chip connect recess cavity and smooth top and bottom surfaces, molded-in-place electrically conductive terminal pins extending from the top surface and protruding from the bottom surface of the planar body member, and a metallized electrically conductive pattern directly deposited on the top surface which enables electrical interconnection between the chip and the terminal pins.

15. A single layer pin grid array integrated circuit chip carrier package comprising a high temperature low dielectric constant thermoplastic planar body member having a central chip connect recess cavity and smooth top and bottom surfaces, electrically conductive metal terminal pins extending from the top surface and protruding from the bottom surface of the planar body member, a chip element having input and output terminal pads located on its top surface and being bonded at its bottom surface to the bottom major surface in the central recess cavity, and an electrically conductive metal trace directly deposited on the top surface of the planar body member after chemical treatment which enables electrical interconnection between the chip and the terminal pins, said chemical treatment providing improved metal adhesion while still preserving unmodified surface smoothness, wherein said interconnection between the chip and the terminal pins is effected by wire elements extending from the terminal pads located on the chip to the metal trace.

16. The chip package of claim 15 which further includes a cover member bonded to the top surface of the planar body member.

17. An integrated circuit chip carrier package comprising a high temperature low dielectric constant thermoplastic planar body member having a central chip connect recess cavity and flat smooth top and bottom surfaces, terminal connections extending between said top and bottom surfaces in the form of electrically conductive metal coated openings, and an electrically conductive metal pattern directly deposited on teh top surface after chemical treatment which enables electrical interconnection between the chip and the terminal connections, said chemical treatment providing improved metal adhesion while still preserving unmodified surface smoothness.

18. The chip package of claim 17 wherein some of the terminal connections are located at the side edges of the planar body member.

19. The chip package of claim 17 wherein the chemically treated surface is produced by chemically modifying the thermoplastic surface with an adhesion promoter.

20. The chip package of claim 17 wherein the electrically conductive metal pattern is copper metal.

21. A method of preparing an integrated circuit chip package comprising the steps of:

(a) molding a high temperature low dielectric constant thermoplastic body member having a central chip recess cavity and smooth major surfaces which further includes a plurality of terminal connections enabling electrical interconnection between the chip package and external terminal means,

(b) treating at least one major surface with an adhesion promoter which chemically modifies the thermoplastic surface to improve metal adhesion while still preserving unmodified surface smoothness, and

(c) depositing an electrically conductive metal trace on the chemically modified surface to enable electrical interconnection between the chip and the terminal connections.

22. The method of claim 21, wherein the conductive metal trace is copper metal.

10784.6-RD-18455

GENERAL ELECTRIC COMPANY

Fig. 1

Fig. 2

Fig.3

Fig.4